# EUROPEAN PATENT APPLICATION

(11) **EP 1 901 117 A1**
(43) Date of publication of application: **19.03.2008**
(21) Application number: 06780800.6
(22) Date of filing: 05.07.2006
(51) Int. Cl.: G03F 1/00, B41C 1/00, B41M 5/00, B41N 1/12, G03F 7/00, G03F 7/105

(54) **METHOD FOR PRODUCING PHOTOSENSITIVE LAMINATE ORIGINAL PRINTING PLATE FOR LETTERPRESS PRINTING, PHOTOSENSITIVE LAMINATE ORIGINAL PRINTING PLATE FOR LETTERPRESS PRINTING, AND METHOD FOR PRODUCING LETTERPRESS PRINTING PLATE**

(30) Priority: 05.07.2005 JP 2005196795
(71) Applicant: TOKYO OHKA KOGYO CO., LTD., Kawasaki-shi, Kanagawa 211-0012 (JP)
(72) Inventor: FUJIMOTO, Takashi, c/o TOKYO OHKA KOGYO CO., LTD., Kawasaki-shi, Kanagawa 211-0012 (JP); NAKAZATO, Syunji, c/o TOKYO OHKA KOGYO CO., LTD., Kawasaki-shi, Kanagawa 211-0012 (JP)
(74) Representative: Maiwald Patentanwalts GmbH
(86) International application number: PCT/JP2006/313424
(87) International publication number: WO 2007/004681

(57) **Abstract**

A mask pattern of high outline precision is formed on a photosensitive resin layer by a step of printing a predetermined pattern of a printing ink composition containing a light-blocking substance for absorbing light in a predetermined wavelength region and curable when receiving a predetermined energy on the photosensitive resin layer formed on a support and exhibiting a sensitivity to light in the predetermined wavelength region or on an intermediate layer formed on the photosensitive resin layer, and a step of forming a mask pattern by applying the predetermined energy to the print pattern to cure the print pattern. The problems when conventional negative films are employed in letterpress printing and when a mask pattern is formed of an ink composition directly on the surface of the photosensitive resin layer can thereby be solved simultaneously.

## Description

### TECHNICAL FIELD

The present invention relates to a method for producing a photosensitive laminate original printing plate for letterpress printing for forming a letterpress printing plate such as a flexographic plate and a photosensitive laminate original printing plate for letterpress printing produced by the method and a method for producing the letterpress printing plate which obtains the letterpress printing plate by using the original printing plate.

### BACKGROUND ART

As is well-known, a photosensitive resin has been used for a recent flexographic original printing plate. The photosensitive resin generally includes an elastomeric binder, at least one monomer, and a photopolymerization initiator. Original printing plates in which the photosensitive resin is used are plate members having at least a photosensitive resin layer provided on a support.

In production of a flexographic plate using this original printing plate, first a film (mask) having a negative pattern of an image such as a text and a picture to be printed is placed on the photosensitive resin layer of this original printing plate, and the photosensitive resin layer is then exposed to actinic rays through this mask. The portion irradiated with actinic rays undergoes a photopolymerization reaction and then is cured (to become a latent image). Subsequently, the uncured portion (removable portion) is washed away with a developing solution, so that a relief pattern corresponding to the image remains. As a result, a flexographic plate is produced. In the flexography, an ink is put on a top surface of the relief pattern, which is compressed on a printing medium such as paper to carry out printing.

A negative film used as the negative mask is produced by the use of a photographic technique commonly used, i.e., a photochemical technique using silver halide, and thus the production is expensive and steps thereof are complicated. Also, in the pattern forming step, a substance such as dust which inhibits light incidence tends to come in between the negative mask and the photosensitive resin layer. If such a substance has come in, a pattern image obtained after the exposure and the development may be disturbed, which may disgrace printing quality of the printing plate.

As an alternative to the photographic film, a negative mask which may be produced more simply and inexpensively has been proposed (Patent Document 1). This negative mask may be produced by the following process: a layer for bearing an ink which may be referred to as an ink receiving layer is provided on a surface of a transparent support substrate such as a polyester film, and printing a negative pattern on this ink bearing layer by an inkjet printer with an ultraviolet light-absorptive ink. However, the point that a substance which inhibits light incidence tends to come in has not been improved.

In order to solve such problems, (Patent Documents 2 and 3) disclose printing with an ink composition which has high absorbency for UV used for the exposure for the photosensitive resin layer using a printing apparatus such as an inkjet printer and a laser printer, whereby printing a negative pattern.
Patent Document 1: Japanese Unexamined Patent Application Publication No. 2003-330158
Patent Document 2: Japanese Unexamined Patent Application Publication No. H5-11445
Patent Document 3: Japanese Unexamined Patent Application Publication No. H10-10709

### DISCLOSURE OF THE INVENTION

### Problems to be Solved by the Invention

The original plate for letterpress printing described in the Patent Documents 2 and 3 has a printed pattern of an ink composition that has directly been printed with the printing apparatus on the surface of a photosensitive resin layer. The printed pattern is then used as a mask for a patterned exposure of the photosensitive resin layer. Thereby, the problems accompanied with the conventional negative film mask may be overcome.

The ink composition is directly printed on the surface of the photosensitive resin layer, and fixed by drying after printing, however, the ink fixity is not satisfactory, and takes time for drying although it is short time, as a result, the bleeding will occur on the printed portion in the meantime. This bleeding results in a new problem to be solved that the contour precision of the mask pattern deteriorates, and a clear print pattern can not be obtained.

It is an object of the present invention to provide a method for producing an original plate for a letterpress printing, which may solve the problems with the conventional negative film, as well as other problems with direct application of the ink composition on a surface of the photosensitive resin layer to form a mask pattern. It is another object of the present invention to provide a method for producing a photosensitive laminate original printing plate for letterpress printing produced by the method, and a letterpress printing plate using the original plate for the letterpress printing. Means for Solving the Problems

As the inventors have conducted extensive studies to solve the abovementioned problems, they have found the following.

That is, a characteristic is given to an ink composition so that the ink cures in response to application of a predetermined energy. When the predetermined energy is applied at the same time of, or immediately after, printing the print pattern, the ink cures before the ink composition bleeds or is repelled on the surface of the photosensitive resin layer, thereby making it possible to enhance the contour precision of the cured pattern mask.

The present invention has been made based on the aforementioned finding. That is, a method for producing a photosensitive laminate original printing plate for letterpress printing according to the present invention is characterized in that the method comprises the steps of: printing a predetermined pattern of a printing ink composition containing a light-blocking substance for absorbing light in a predetermined wavelength region and curable by receiving a predetermined energy on a photosensitive resin layer formed on a support and exhibiting a sensitivity to light in the predetermined wavelength region, or on an intermediate layer formed on the photosensitive resin layer; and forming a pattern mask by application of the predetermined energy to the print pattern to cure the printing ink composition.

It is desirable that the application of the predetermined energy is performed at the same time of, or immediately after, printing the print pattern. This makes it possible to cure the print pattern before the printing ink composition bleeds on a surface of the photosensitive resin layer, thereby enhancing contour precision of the pattern mask.

As the predetermined energy, it is desirable to use a thermal energy and actinic rays. As the thermal energy to be used, a thermal energy, which causes the temperature of the print pattern to be 30 to 90°C by the application of the thermal energy to the print pattern, is preferable.

In the printing step of printing a pattern, it is preferable that the print pattern of the printing ink composition is printed by using an ink jet printing device.

Moreover, a photosensitive laminate original printing plate for letterpress printing according to the present invention is characterized in that it has been obtained by the method for producing a photosensitive laminate original printing plate for letterpress printing.

A method for producing a letterpress printing plate according to the present invention is characterized in that it comprises: an exposing step of radiating light in a predetermined wavelength region through a pattern mask to the photosensitive laminate original printing plate for letterpress printing; and a developing step of removing a removable part of the photosensitive resin layer with a developing solution.

### Effects of the Invention

With the abovementioned configuration, the print pattern of the printing ink composition formed on the surface of the photosensitive resin layer is quickly cured by applying a predetermined energy, thereby fixing the print pattern on the surface of the photosensitive resin layer without bleeding of the ink constituting the print pattern. By these, a pattern mask with high contour precision can be obtained, thereby making it possible to form a pattern of a photosensitive resin layer suitable for letterpress printing, by the exposure through this pattern mask and the development thereafter.

### PREFERRED MODE FOR CARRYING OUT THE INVENTION

Constituent factors of the original plate for the letterpress printing of the present invention will be illustrated in more detail with reference to the following example of the flexographic original plate.

### [Support substrate]

A support substrate which constitutes the flexographic original plate of the present invention may be any of support substrates which meet physical performance such as mechanical strength required for a printing condition in a flexographic printing, and examples thereof may be any of publicly known support substrates for usual flexographic printing, such as metals, plastic films, paper and complexes thereof. These include polymer films comprised of an addition polymerization polymer or a linear condensed polymer, transparent foam, woven fabric, nonwoven fabric, such as glass fiber fabric, and metals such as steel and aluminum. The support substrate is preferably transparent to non-infrared ray so that back exposure is facilitated. A more preferable support substrate may include a polyethylene or polyester film, and particularly a polyethylene terephthalate film is favorable. As the film, a film with a thickness of 50 to 300 µm, and preferably a film with a thickness of 75 to 200 µm is used. This support substrate layer may be optionally coated with a thin adhesiveness accelerating layer between the photosensitive resin layer and the support substrate, if necessary. As this adhesiveness accelerating layer, for example, a mixture of polycarbonate, a phenoxy resin and polyvalent isocyanate may be suitably used.

### [Photosensitive resin layer]

A photosensitive resin layer used for the flexographic original plate of the present invention may be formed by a photosensitive resin composition containing an elastomeric binder, one or more monomers and a photopolymerization initiator, and all of the photosensitive resin compositions suitable for the flexography may usually be used. Examples of the elastomeric binder may include polymers such as a homopolymer, a copolymer and a mixture thereof which have an elastomeric property, and are soluble in, swellable with or dispersible in a developer of an aqueous or an organic solvent, and capable of being washed out. Examples of binders include polybutadiene, polyisoprene, polydiolefin, vinyl aromatic compound/diolefin copolymers and block copolymers, styrene/butadiene copolymers, styrene/isoprene copolymers, diolefin/acrylonitrile copolymers, ethylene/propylene copolymers, ethylene/propylene/diolefin copolymers, ethylene/acrylic acid copolymers, diolefin/acrylic acid copolymers, diolefin/acrylate/acrylic acid copolymers, ethylene/(meth)acrylic acid/(meth)acrylate copolymers, polyamide, polyvinyl alcohol, polyvinyl alcohol/polyethylene glycol graft copolymers, amphoteric interpolymers, celluloses such as alkyl cellulose, hydroxyalkyl cellulose and nitrocellulose, ethylene/vinyl acetate copolymers, cellulose acetatebutyrate, polybutylal, cyclic rubbers, styrene/acrylic acid copolymers, polyvinyl pyrrolidone, copolymers of polyvinyl pyrrolidone and vinyl acetate, chloroprene polymers, styrene-chloroprene copolymers, acrylonitrile-butadiene copolymers, acrylonitrile-isoprene copolymers, acrylonitrile-chloroprene copolymers, methyl methacrylate-butadiene copolymers, methyl methacrylate-isoprene copolymers, methyl methacrylate-chloroprene copolymers, methyl acrylate-butadiene copolymers, methyl acrylate-isoprene copolymers, methyl acrylate-chloroprene copolymers, acrylonitrile-butadienestyrene copolymers, acrylonitrile-isoprene-styrene copolymers, acrylonitrile-chloroprene-styrene copolymers, epichlorohydrin polymers, epichlorohydrin-ethylene oxide copolymers, epichlorohydrin-propylene oxide copolymers, epichlorohydrin rubbers, chlorinated polyethylene, vinyl chloride copolymers, vinylidene chloride copolymers, chlorinated polypropylene, chlorinated ethylene-propylene rubbers, ethyl acrylate-acrylonitrile copolymers, butyl acrylate-acrylonitrile copolymers, methyl methacrylate-acrylonitrile copolymers, and butyl acrylate-styrene-acrylonitrile copolymers. The polymers may be used alone or in combination. In addition, the resin that is a binder which can be dissolved or dispersed in an aqueous developer and which is disclosed in United States Patent Nos. 3,458,311', 4,442,302, 4,361,640, 3,794,494, 4,177,074, 4,431,723, 4,517,279 and the like, and the resin which can be dissolved, swollen or dispersed in an organic solvent developer and which is disclosed in United States Patent Nos. 4,323,636, 4,430,417, 4,045,231 and the like can be also exemplified.

One or more sorts of monomers contained in the photosensitive resin layer used for the present invention are required to be compatible with the binder so that the transparent photosensitive resin layer with no haze may be formed. Examples of the monomers may include aromatic vinyl monomers such as α-methylstyrene, m-methylstyrene and p-methoxystyrene, α,β-ethylenic unsaturated nitrile compounds such as acrylonitrile and methacrylonitrile, acrylates of alkyl alcohol having 1 to 23 carbon atoms such as methyl acrylate, ethyl acrylate, propyl acrylate, n-butyl acrylate, isobutyl acrylate and t-butyl acrylate, and corresponding methacrylates, acrylates of hydroxyalkyl alcohol such as 2-hydroxyethyl acrylate and 2-hydroxypropyl acrylate, and corresponding methacrylates, acrylates of alkoxy alkyleneglycol such as methoxy ethyleneglycol and methoxy propyleneglycol, and corresponding methacrylates, monoesters of an unsaturated polycarboxylic acid such as monoethyl maleate, monomethyl fumarate, and monoethyl itaconate; diesters such as dimethyl maleate, diethyl maleate, dibutyl maleate, dioctyl maleate, diethyl fumarate, dibutyl fumarate, dioctyl fumarate, dimethyl itaconate, diethyl itaconate, dibutyl itaconate, and dioctyl itaconate, acrylamides such as acrylamide, methacrylamide, N,N'-methylenebisacrylamide and N,N'-hexamethylenebisacrylamide, and corresponding methacrylamides, diacrylates of glycol such as ethylene glycol diacrylate and polyalkylene glycol (having 2 to 23 alkylene glycol units), and corresponding methacrylates, diacrylates, triacrylates, tetraacrylates and oligo acrylates of a trihydric or more alcohol, i.e., polyhydric alcohol such as glycerol, pentaerythritol, trimethylolalkane or tetramethylolalkane (examples of alkanes include methane, ethane and propane), and corresponding methacrylates, and acrylates having an acid functional group such as 2-(acryloyloxy)ethyl succinate, 2-(acryloyloxy)ethyl hexahydrophthalate and 2-(acryloyloxy)ethylacid phosphate, and corresponding methacrylates. Any one of these photopolymerizable ethylenic unsaturated monomers may be used alone, or in combination of two or more thereof. Additional examples of the monomers may include those described in US Patent Nos. 4,323,636, 4,753,865, 4,726,877 and 4,894,315.

The photosensitive resin layer contains the monomer at 5 to 30 parts by weight, and preferably 10 to 20 parts by weight based on 100 parts by weight of the binder in the photosensitive resin layer. A monomer content less than the aforementioned range in the flexographic plate is not preferable because abrasion resistance and chemical resistance of a coating film after being cured with exposure of non-infrared radiation may be reduced. The monomer content more than the aforementioned range also is not preferable because the elastomeric property of the photosensitive resin layer may be reduced.

As the photopolymerization initiator, any of publicly known initiators may be used. Examples of such a photopolymerization initiator may include aromatic ketones such as benzophenone; benzoin ethers such as benzoin methyl ether, benzoin ethyl ether, benzoin isopropyl ether, α-methylolbenzoin methyl ether, α-methoxybenzoin methyl ether and 2,2-diethoxyphenylacetophenone; substituted or unsubstituted polynuclear quinones; 1-hydroxycyclohexylphenylketone, 2,2-dimethoxy-1,2-diphenylethane-1-one, 2-methyl-1-[4-(methylthio)phenyl]-2-morpholinopropane-1-one, 2-benzyl-2-dimethylamino-1-(4-morpholinophenyl)-butane-1-one, 2-hydroxy-2-methyl-1-phenylpropane-1-one, 2,4,6-trimethylbenzoyldiphenylphosphine oxide, 1-[4-(2-hydroxyethoxy)phenyl]-2-hydroxy-2-methyl-1-propane-1-one, 2,4-diethylthioxanthone, 2-chlorothioxanthone, 2,4-dimethylthioxanthone, 3,3-dimethyl-4-methoxybenzophenone, benzophenone, 1-chloro-4-propoxythioxanthone, 1-(4-isopropylphenyl)-2-hydroxy-2-methylpropane-1-one, 1-(4-dodecylphenyl)-2-hydroxy-2-methylpropane-1-one, 4-benzoyl-4'-methyldimethylsulfide, 4-dimethylaminobenzoic acid, methyl 4-dimethylaminobenzoate, ethyl 4-dimethylaminobenzote, butyl 4-dimethylaminobenzoate, 2-ethylhexyl 4-dimethylaminobenzoate, 2-isoamyl 4-dimethylaminobenzoate, 2,2-diethoxyacetophenone, benzyldimethylketal, benzyl-β-methoxyethylacetal, methyl o-benzoylbenzoate, bis(4-dimethylaminophenyl)ketone, 4,4'-bisdiethylaminobenzophenone, 4,4'-dichlorobenzophenone, benzyl, benzoin, benzoinmethyl ether, benzoinethyl ether, benzoinisopropyl ether, benzoin-n-butyl ether, benzoinisobutyl ether, p-dimethylaminoacetophenone, p-tert-butyltrichloroacetophenone, p-tert-butyldichloroacetophenone, 2-(o-chlorophenyl)-4,5-diphenylimidazolyl dimer, thioxanthone, 2-methylthioxanthone, 2-isopropylthioxanthone, dibenzosuberone, α,α-dichloro-4-phenoxyacetophenone, pentyl-4-dimethylaminobenzoate, 9-phenylacridine, 1,7-bis-(9-acridinyl)heptane, 1,5-bis-(9-acridinyl)pentane, 1,3-bis-(9-acridinyl)propane, and the like. In addition, other examples include initiators disclosed in the specifications of U.S. Patent Nos. 4,460,675 and 4,894,315. The initiators may be used alone or in combination.

It is preferable to contain the initiator in the range of 0.001 to 10% by weight based on a total weight of the photosensitive resin.

Furthermore, additives such as a sensitizer, a heat polymerization inhibitor, a plasticizer and a colorant may be used in the photosensitive resin composition which forms the photosensitive resin layer, depending on a required property. Various methods may be used as a method for preparing this photosensitive resin composition. For example, components may be dissolved and mixed in an appropriate solvent such as hydrocarbons such as chloroform and tetrachloroethylene, ethers such as dibutyl ether, isopropyl ether, dioxane and tetrahydrofuran, ketones such as acetone, diethylketone, methylethylketone, methylisobutylketone, methylpropylketone, and cyclohexanone, esters such as ethyl acetate, n-propyl acetate and n-butyl acetate, and aromatic hydrocarbons such as benzene, toluene and xylene (these organic solvents may be used alone or in combination), and the solution may be poured and spread in a mold. Evaporation of the solvent therefrom may give a plate. Alternatively without using the solvent, the components may also be kneaded in a kneader or a roll mill, and molded into a plate with desired thickness by an extruder, an injection molding machine or a press machine.

As a printing ink composition (hereinafter referred to as an "ink composition") to be used for the present invention, a heat-curable ink and an ultraviolet-curable ink can be preferably used. As the heat-curable ink and external-radiation-curable ink, an ink including pigments having absorption characteristics for the light in a wavelength region of 300 to 400 nm can be preferably used. The light in a wavelength region of 300 to 400 nm is the light used as the exposure light for patterning the photosensitive resin layer of the original printing plate. These ink compositions include ink compositions described in Japanese Unexamined Patent Application Publications No. 2005-113147, No. 2004-114693, No. 2003-213185, No. 2002-332433, No. 2002-332434, No. 2003-182204 and No. H10-230675.

As the heat-curable ink, an ink which cures when heated to 30 to 90°C can be preferably used.

As the heat-curable ink having the abovementioned characteristics, an ink of the following composition can be preferably used.

For example, the heat-curable ink includes a heat-curable ink composed of a fluid medium, a colorant and polymer binder as described in Japanese Unexamined Patent Application Publication No. 2005-113147. Moreover, the ink may contain a pH control agent as an additive.

The fluid medium may include a prime solvent, and may be the following aqueous carrier medium as described in Japanese Unexamined Patent Application Publication No. 2004-114693. A fluid medium containing a prime solvent and dry inhibitor is particularly preferable. Examples of the prime solvent include water and desalted water. Moreover, the dry inhibitor includes, for example, polyhydric alcohol as the following moisturizing agent, specifically glycol, and more specifically butyl diglycol, diethylene glycol and Solvenon.

The colorant includes pigment having the abovementioned characteristics. Though examples include pigment as described in Japanese Patent Application No. 2004-114693 to be described later, titanium oxide, iron oxide, carbon black and pigment black 7 are more preferable.

The polymer binder includes (meth)acrylate resin (hereinafter, the notion of acrylate resin includes methacrylate). The acrylate resin exists in dissolved state in the basic region; on the other hand, it is insoluble in the acidic region or neutral region. The pH value of the ink of the present invention is greater than 7.5 until the print pattern printing process (hereinafter, printing process), more preferably greater than 8.5. Therefore, the binder exists in dissolved state in ink. By a desired sudden change of pH value from basic region to acidic region, the binder, which is controlled pH value intentionally by the quantity of pH adjuster, cures. Since the amine, in other words, the volatile substance volatilizes after the printing step, the ratio of amine decreases, and the pH value changes to acidic property, the binder cures, and a dried ink layer (pattern mask) with good contour precision which is resistant to scratching on the printing medium is produced.

The pH control agent includes amine or amine containing material. By employing basic amine or basic amine containing material, the ink produced therewith becomes basic, thereby reducing the abrasion of the print head, and extending the durability period of the ink feeding system. In this case, the ink has the pH value which is greater than 7.5, preferably greater than 8.5.

Examples of the amine include ethanolamine, triethanolamine, ammonia solution, dimethyl ethanolamine and mixture thereof. The amine used in ink is expressed by the following general formula

N (R₁R₂R₃)

wherein the R₁, R₂ and R₃ residues are each independently the group selected from hydrogen atom (H), methyl group (CH₃), ethyl group, ethanol group (CH₂CH₂OH).

Preservative and moistening agent may be contained as other additives. The preservative includes, for example, triazin and a solution of isothiazolinone derivative. ProxelG, GrotanBK, ParmetolK40 and ParmetolA28 are examples of commercially available items. The moistening agent includes a fluorine-based surfactant, silicone surfactant and aliphatic alcohol polyglycol ether.

In addition, the heat-curable ink includes, for example, a heat-curable ink composed of a pigment, a polymer and an aqueous carrier medium as described in Japanese Unexamined Patent Application Publication No. 2004-114693.

The pigment may be a self-dispersible pigment as described in U.S. Patent No. 5,630,868, or may be a capsulation pigment as described in U.S. Patent Application No. 09/822,723 in application pendency which was filed on 30 March 2001, or may be stabilized by a dispersing agent. In the present invention, a wide variety of organic and inorganic pigments can be used alone or in combination. The colorant particle which can be used in the present invention includes, for example, pigments disclosed in Japanese Unexamined Patent Application Publication No. 2004-114693, U.S. Patent No. 5,026,427, U.S. Patent No. 5,086,698, U.S. Patent No. 5,141,556, U.S. Patent No. 5,160,370 and U.S. Patent No. 5,169,436 (the disclosures thereof are hereby incorporated in the present specification by reference). The exact choice of pigments will depend upon the specific application and performance requirements such as color reproduction and image stability. Pigments suitable for use in the present invention include, for example, azo pigments, monoazo pigments, disazo pigments, azo pigment lakes, β -Naphthol pigments, Naphthol AS pigments, benzimidazolone pigments, disazo condensation pigments, metal complex pigments, isoindolinone and isoindoline pigments, polycyclic pigments, phthalocyanine pigments, quinacridone pigments, perylene and perinone pigments, thioindigo pigments, anthrapyrimidone pigments, fiavanthrone pigments, anthanthrone pigments, dioxazine pigments, triarylcarbonium pigments, quinophthalone pigments, diketopyrrolo pyrrole pigments, titanium oxide, iron oxide, and carbon black. Titanium oxide, iron oxide, carbon black and pigment black 7 are more preferable.

The polymers are essentially hydrophobic polymers of any composition that can be stabilized but not dissolved in water-based ink medium. These can be used either polymer latex or water dispersible polymer. Such hydrophobic polymers are generally classified as either condensation polymer or additional polymers. Condensation polymers include, for example, polyesters, polyamides, polyurethanes, polyureas, polyethers, polycarbonates, polyacid anhydrides, and polymers comprising combinations of the above-mentioned ones. Addition polymers are polymers formed from polymerization of vinyl-type monomers including, for example, allyl compounds, vinyl ethers, vinyl heterocyclic compounds, styrenes, olefins and halogenated olefins, unsaturated acids and esters derived therefrom, unsaturated nitrites, vinyl alcohols, acrylamides and methacrylamides, vinyl ketones, multifunctional monomers, or copolymers formed from various combinations of these monomers. Most of monomer units in the polymer used in the invention may be hydrophobic, and the content of the hydrophilic monomer is less than 25% by weight of the total polymer, more preferably less than 10% by weight of the total polymer, most preferably less than 5% by weight of the total polymer.

In a preferred embodiment of the invention, the polymer latex or water dispersible polymer is a styrene/ acrylic polymer, a polyester or a polyurethane. The first sort of preferred polymer includes those styrene/acrylic polymers prepared by free-radical polymerization of vinyl monomers in aqueous emulsion. The polymer latex can be homopolymer or copolymer or cross-linked polymers comprising ethylenically-unsaturated hydrophobic monomers which form water-insoluble homopolymers are preferred, as are copolymers of such monomers, which may also comprise ethylenically-unsaturated hydrophilic monomers which give water-soluble homopolymers, if the overall polymer composition is sufficiently water-insoluble to form a latex.

In a preferred embodiment of the invention, the ethylenically-unsaturated monomers are halogenated. Examples include vinyl chloride, vinylidene chloride, vinyl fluoride, vinylidene fluoride, vinyl bromide and vinylidene bromide, chloromethacrylic acid and the like.

The second sort of polymer used in the invention may be water dispersible polyesters. Examples of water dispersible polyesters useful in present invention include Eastman AQ (registered) polyesters, (Eastman Chemical Company). Eastman Polyesters AQ 29, AQ 38, and AQ 55 are composed of varying amounts of isophthalic acid, sodium sulfoisophthalic acid, diethylene glycol, and 1,4-cyclohexanedimethanol. These thermoplastic, amorphous, ionic polyesters are prepared by a molten-phase condensation polymerization at high temperature and low pressure, and the molten product is extruded into small pellets. The solid polymer disperses readily in water at 70°C with minimal agitation to give transparent, low viscosity dispersions containing no added surfactants or solvents. Varying the amount of ionic monomers, i.e., sulfoisophthalic acid, can control the particle size. The particle sizes range from 0.02 to 0.1µm.

The third sort of polymer used in present invention may be an aqueous dispersible polyurethanes. Useful polyurethanes are disclosed in U.S. Patent Application No. 09/548,514, filed on 13 April 2000, by Yacobucci et al., the disclosure of which is hereby incorporated by reference. These materials may be prepared as described in "Polyurethane Handbook," Hanser Publishers, Munich Vienna, 1985. Examples of aqueous dispersible polyurethanes are Witcobond (registered) polyurethane dispersion such as W-240, W-232 and W-254 by Crompton Corp. or Sancure (registered) polyurethane by BF Goodrich Company.

The aqueous carrier medium for the ink composition is water or a mixture of water and at least one water miscible co-solvent. Selection of a suitable mixture depends on requirements of the specific application, such as desired surface tension and viscosity, the selected pigment, drying time of the pigmented ink jet ink, and the type of paper onto which the ink will be printed. Representative examples of water-miscible co-solvents that may be selected include (1) alcohols, such as methyl alcohol, ethyl alcohol, n-propyl alcohol, isopropyl alcohol, n-butyl alcohol, sec-butyl alcohol, t-butyl alcohol, iso-butyl alcohol, furfuryl alcohol, and tetrahydrofurfuryl alcohol; (2) ketones or ketoalcohols such as acetone, methyl ethyl ketone and diacetone alcohol; (3) ethers, such as tetrahydrofuran and dioxane; (4) esters, such as ethyl acetate, ethyl lactate, ethylene carbonate and propylene carbonate; (5) polyhydric alcohols, such as ethylene glycol, diethylene glycol, triethylene glycol, tetraethylene glycol, propylene glycol, polyethylene glycol, glycerol, 2-methyl-2,4-pentanediol 1,2,6-hexanetriol and thioglycol; (6) lower alkyl mono- or di-ethers derived from alkylene glycols, such as ethylene glycol mono-methyl (or -ethyl) ether, diethylene glycol mono-methyl (or -ethyl) ether, diethylene glycol mono-butyl (or -ethyl) ether, propylene glycol mono-methyl (or -ethyl) ether, poly(ethylene glycol) butyl ether, triethylene glycol mono-methyl (or -ethyl) ether and diethylene glycol di-methyl (or -ethyl) ether; (7) nitrogen containing cyclic compounds, such as pyrrolidone, N-methyl-2-pyrrolidone, and 1,3-dimethyl-2-imidazolidinone; and (8) sulfur-containing compounds such as dimethyl sulfoxide, 2,2'-thiodiethanol, and tetramethylene sulfone. As for water, ionexchange water (deionized water) is preferably used to general water containing various kinds of ions. The ink preferably used in the present invention is a water type (water-based) ink, and the water content is preferably equal to or more than 50% based on the total mass of the ink.

Moreover, surfactant, moisturizing agent, penetrant, biocide, thickener, conductivity promoter, an antikogation agent, a pH buffer, desiccant and a defoaming agent may be added. The moisturizing agent includes polyhydric alcohols. For example, ethylene glycol, diethylene glycol, triethylene glycol, propylene glycol, tetraethylene glycol, polyethylene glycol, butyl diglycol, Solvenon, glycerol, 2-methyl-2,4-pentanediol, 1,2,6-hexanetriol and thioglycol are included. Preferably, a mixture of diethylene glycol or glycerol and diethylene glycol is preferred.

The ultraviolet-curable ink includes, for example, an ultraviolet-curable ink composed of functional alkoxy or polyfunctional polyalkoxyacrylate monomer, photopolymerization initiator and colorant as described in Japanese Published Patent Application No. 2000-504778, and an ultraviolet-curable ink which is composed of monomer, polymerization initiator, coloring material and aqueous liquid medium, and which solidifies when an energy is applied thereto, as described in Japanese Unexamined Patent Application Publication No. 2003-213185. Moreover, the ink may contain a dispersing agent, a pH control agent, surfactant, moisturizing agent, antifoamer and antiseptic agent as an additive.

It is desirable that polyfunctional alkoxy or polyalkoxy acrylate monomer is composed of one or more diacrylate or triacrylate. However, alkoxy or the polyalkoxy acrylate monomer having higher functionality can be used alone or together with one or more bifunctional and/or trifunctional substance. It is more desirable that total amount of the multifunctional substance (alkoxylated ones + polyalkoxylated ones) is in the range of 80 to 95% by weight of all compositions. It is desirable that the number of alkoxyl groups is from 1 to 20 per one monomer molecule. Moreover, it is desirable that the alkylene oxy group is a C2 to C4 alkylene oxy group, and it is more desirable that it is an ethoxy (EO) or propoxy (PO) group.

Preferred polyfunctional alkoxy or the polyalkoxy acrylate can be selected from alkoxylation substances, and desirably from the following ethoxylated or propoxylated substances. That is, it can be selected from neopentylglycol diacrylate, butanediol diacrylate, trimethyl propane triacrylate and glyceryl triacrylate.

Furtermore, the composition of the present invention can contain, depending on the necessity, monofunctional alkoxy or polyalkoxy acrylate monomer up to 10% by weight of all compositions. This monomer can be selected from one or more alkoxylated substances, for example from the following ethoxylated or propoxylated substances. That is, it can be selected from tetrahydrofurfuryl acrylate, cyclohexyl acrylate, alkyl acrylates, nonyl-phenol acrylate and polyethylene, or polypropylene glycol acrylate.

The compositions of the present invention can also include, for example, octyl acrylate, decyl acrylate, N-vinylpyrrolidone, ethyl diglycol acrylate, isobutyl acrylate ethyl-hexyl acrylate, lauryl acrylate, butanediol monoacrylate, β-carboxyethyl acrylate, isobutyl acrylate polypropyleneglycol monomethacrylate, 2-hydroxyethyl methacrylate, bifunctional (meth)acrylate acid ester, and desirably including monofunctional or multifunctional non-alkoxy radiation curable monomer selected one or more from hexanediol dimethacrylate, tetraethyleneglycol diacrylate, tripropyleneglycol diacrylate, butanediol diacrylate, polyethyleneglycol diacrylate, and triethyleneglycol dimethacrylate, in the range that is not more than 5 weight % of all composition. However, it is the most desirable to completely exclude such a non-alkoxy monomer.

The monomer which solidifies by application of an energy includes an ultra-violet rays polymerizable monomer, and requires abilities such as (1) high solubility to water, (2) low viscosity, (3) photopolymerizability and (4) superior physical property of cured films. Acrylic monomers of radical polymerization can be preferably used as this monomer.

The acrylic monomers of the radical polymerization particularly preferably include,N,N-dimethylaminoethyl methacrylate, N,N-dimethylaminoethyl acrylate, N,N-dimethylaminopropyl methacrylate, N,N-dimethylaminopropyl acrylate, N,N-dimethylamino acrylamide, N,N-dimethylamino methacrylamide, N,N-dimethylamino ethylacrylamide, N,N-dimethylaminoethyl methacrylamide, N,N-dimethylaminopropyl acrylamide, N,N-dimethylaminopropyl methacrylamide, and the quaternized material of these by its superior dyeing property of coloring material. Also, UV curable monomer and oligomer known in the art, such as (meth)acrylic acid ester of the polyhydric alcohol, (meth)acrylic acid ester of glycidyl ether of the polyhydric alcohol, (meth)acrylic acid ester of polyethyleneglycol, (meth)acrylic acid ester of ethylene oxide addition compound of the polyhydric alcohol, reactant of polybasic acid anhydride and (meth)acrylic acid ester containing hydroxy group are used. Substances with high compatibility and hydrophilic property with the ink are appropriately selected from these materials and used.

Photopolymerization initiator can be used for a polymerization initiator. As the usage of the photopolymerization initiator, one or more photoinitiator may be used, or photoinitiator and sensitizer may be used. Selection, combination and a blending ratio of the main photoinitiator and sensitizer may be appropriately selected depending on the monomer and device to be used.

The photoinitiator and the sensitizer include, for example, as for photoinitiator, acetophenone, 2,2-diethoxyacetophenone, p-dimethylaminoacetophenone, p-dimethylaminopropiophenone, benzophenone, 2-chlorobenzophenone, p,p'-dichlorobenzophenone, p,p'-bisdiethylaminobenzophenone,-Michler's ketone benzyl, benzoin, benzoin methyl ether, benzoin ethyl ether, benzoin isopropyl ether, benzoin n-propyl ether, benzoin isobutyl ether, benzoin n-butyl ether, benzyl dimethyl ketal, tetramethyl thiuram mono sulfide, thioxanthone, 2-chlorothioxanthone, 2-methylthioxanthone, azobisisobutyronitrile, benzoinperoxide, di-tert-butylperoxide, 1-hydroxycyclohexyl phenyl ketone, 2-hydroxy-2-methyl-1-phenyl-1-one, 1-(4-isopropylphenyl)-2-hydroxy-2-methylpropan-1-one, and methylbenzoyl formates.

Also, in the cation polymerization type reaction, photoinitiator such as aromatic diazonium salts, aromatic halonium salts, aromatic sulfonium salts, metallocene compounds is used. Examples thereof may include such as triphenylsulfonium hexafluorophosphate and diphenyliodonium hexafluoroantimonate.

Examples of the sensitizer include (1) amines: aliphatic amines, amines containing the aromatic group, piperidine, (2) ureas: allyl ureas, o-tolylthio urea, (3) sulfur compounds: sodium diethyl dithiophosphate, soluble salt of the aromatic sulfinic acid, (4) nitryl compounds: N,N-disubstituted-p-aminobenzonitryl, (5) phosphorus compounds: tri-n-butylphosphine, sodiumdiethyl dithiophosphide, (6) nitrogen compounds: Michler's ketone, N-nitrosolhydroxylamine derivatives, oxazolidine compounds, tetrahydro-1,3-oxazine compounds, condensate of formaldehyde or acetaldehyde and diamines (7) chlorine compounds: carbon tetrachloride, hexachlorethane (8) polymerized amines of the reaction product of epoxy resin and amines, triethanolamine triacrylate.

As the coloring material, any one of a water soluble dye dissolved in an aqueous liquid medium and a pigment dispersion in which inorganic pigment or organic pigment is dispersed to an aqueous liquid medium with a dispersing agent is applicable. In cases where ultra-violet rays are illuminated to a print after recording, however, it is preferable to use a dye or pigment which is stable against light. As the dye to be used, various kinds of publicly known dyes can be used. Examples include azo dye as a direct dye, phthalocyanine dye, azo dye as acid dye, anthraquinone dye, a metallic complex of reactive dye, a polyvalent metal salt and the like. As the pigment to be used, all of conventionally publicly known organic and inorganic pigments can be used. For example, the abovementioned pigments are included. Titanium oxide, iron oxide, carbon black and pigment black 7 is more preferable.

Water-soluble resin (dispersion resin) can be contained in the ink as a dispersing agent to disperse the pigment. It is preferable that the water-soluble resin is soluble in a water solution in which amine or base is dissolved, and that a weight average molecular weight thereof is in the range of 3000 to 30000. Furthermore, the weight average molecular weight of 5000 to 15000 is preferably used. For example, styrene-acrylic acid copolymer, styrene-acrylic acid -alkyl acrylate ester copolymer, styrene-maleic acid copolymer, styrene-maleic acid-alkyl acrylate ester copolymer, styrene-methacrylic acid copolymer, styrene-methacrylic acid -alkyl acrylate ester copolymer, styrene-maleic acid half ester copolymer, vinylnaphthalene-acrylic acid copolymer, vinylnaphthalene-maleic acid copolymer, styrene-maleic anhydride-maleic acid half ester copolymer or salt thereof can be used.

As pH control agent, various organic amines such as diethanolamine and triethanolamine; inorganic alkaline chemicals of hydroxide of alkali metals such as sodium hydroxide, lithium hydroxide and potassium hydroxide; organic acid and mineral acid are included. The aqueous liquid medium includes aforementioned aqueous carrier medium.

No precipitation and no separation occur in this ink composition during the storage. Therefore, when this ink composition is used in the inkjet printer, a jet opening at an inkjet recording head is never occluded. In the ink composition used for the present invention, no change of physical quality occurs even when used for a relatively long time under a certain recycle in a continuous mode of inkjet printer or used intermittently in an on-demand mode of inkjet printer. Also, the ink of the present invention may be provided as an ink stock solution.

This ink composition can block the light for exposure in the production of the letterpress printing plate because it has a high absorbance of the light in a wide wavelength region (300nm to 400nm) centered on 350 nm. Pigments suitably used for this ink composition has high solubility in an aqueous solvent, and thus a pigment concentration can be made high, thereby forming a pattern mask with high light-shielding ability. A high-definition pattern mask may be formed by using an inkjet system because no crystal of the pigment is precipitated, a jetting path is not bended and no clogging occurs at the jet opening.

Subsequently, a specific example of the method for producing the flexographic laminate original plate of the present invention are described. First, a photosensitive resin composition prepared by mixing an elastomeric binder, a monomer, a polymerization initiator and other ingredients is formed into a hot melt, and this is calendared so as to have a desired thickness. Alternatively, using an extruder, the photosensitive resin composition is melted, mixed, degassed and filtrated, and subsequently extruded between a support and a temporary cover sheet, which is calendared to have a desired thickness. Alternatively, the photosensitive resin layer is formed on the support by a method in which the support and the cover sheet are placed in a die and the photosensitive resin composition is extruded between them. Subsequently, an intermediate layer may be formed on the photosensitive resin layer if necessary.

The intermediate layer can be appropriately used as long as it is a polymer having a film forming ability. From the viewpoint of keeping quality, a polymer, which has the film forming ability, but which does not substantially have moisture-absorption property, is preferred, and an example thereof includes polyamide.

The print pattern is printed on the surface of the photosensitive resin layer or intermediate layer of the flexographic laminate original plate obtained by the above mentioned method, using the ink composition and inkjet printer. The predetermined energy such as heat or actinic rays is applied at the same time of, or immediately after, this printing, thereby curing the print pattern to form the pattern mask. As such a predetermined energy, heat and actinic rays such as ultra-violet rays or electron beams are preferred. This predetermined energy is heat in cases where the ink composition is a heat-curable ink, and this predetermined energy is ultra-violet rays in cases where the ink composition is ultraviolet-curable ink.

The flexographic printing plate is produced by irradiating the light in a wavelength region of 300 to 700 nm to the laminate original printing plate where the pattern mask has been formed on the photosensitive resin layer, removing by a developer a non-irradiated area (removable portion) of the photosensitive resin layer, where the photosensitive resin layer is not irradiated or cured because this light is blocked with a pattern mask to form into a printing plate image.

Chemical radiation irradiated on the photosensitive resin layer is electromagnetic wave with shorter wavelength than that of infrared light, preferably electromagnetic wave of visual light and ultraviolet light region, more preferably electromagnetic wave of 300 to 700 nm, and still more preferably electromagnetic wave of 300 to 400 nm. Examples of a light source of this chemical radiation may include a low pressure mercury lamp, a high pressure mercury lamp, an ultraviolet fluorescent light, a carbon arc lamp, a heavy hydrogen lamp, a tungsten lamp (tungsten iodine lamp, WI lamp, WI₂ lamp), a xenon lamp, and an excimer laser. The developing solution used in the development treatment may be any of an organic solvent, water, and an aqueous or semi-aqueous solvent as long as it has a property of dissolving the photosensitive resin layer, and the developing solution is selected depending on the chemical properties of the resin to be removed. Examples of appropriate organic solvent developing solutions include aromatic or aliphatic hydrocarbon solvents, aliphatic or aromatic halohydrocarbon solvents, and mixtures of the above solvents with appropriate alcohols. The semi-aqueous developing solution contains water or an organic solvent miscible with water, and an alkaline material. Examples of the aqueous developing solutions include aqueous solutions obtained by dissolving in water, e.g., esters such as heptyl acetate or 3-methoxybutyl acetate; hydrocarbons such as petroleum fraction, toluene or decalin; chlorine containing solvents such as tetrachloroethylene; amines such as monoethanolamine, diethanolamine or triethanolamine; sodium hydroxide, potassium hydroxide, sodium carbonate, or ammonia. Alternatively, a mixture of the above solvents and alcohols such as propanol, butanol or pentanol can be used. In washing with solvents, an arbitrary method such as dipping, spraying from a nozzle or brushing using a brush can be employed.

An inkjet printer is suitable for a printing apparatus capable of being suitably used for printing the print pattern because it is economical and effective pattern can be formed. Printing by the inkjet printer forms texts and pictures by jetting the ink from a nozzle onto a recording material such as paper. The method for printing, depending on methods of jetting the ink, may be roughly classified into a piezo method in which mechanical vibration is given to ink to jet using piezoelectric elements and a bubble jet (registered) in which jetting the ink by taking advantage of a pressure generated by heating the ink to produce bubbles.

As described previously, the method for printing the print pattern using the ink composition in the present invention is preferably an inkjet recording method, and the method may be any method as long as the ink can be effectively released from the nozzle and imparted to a recording medium in a shooting range. In particular, an inkjet mode (bubble jet (registered) mode) where an ink received a thermal energy is rapidly changed in volume by bubbling and the ink is jetted from a nozzle by an action force due to this change, which is a method described in Japanese Unexamined Patent Application Publication No. S54-59936 may be effectively used.

In the present invention, it is important to apply the predetermined energy such as heat or actinic rays at the same time of, or immediately after, printing the print pattern to quickly cure the print pattern, and it is preferable to provide energy application means, for that purpose, to the ink jet printing device.

For example, in the case of the heat-curable ink, it is preferable to use a printing system provided with a heating device such as a laser, a hot plate or an infrared heater. It is preferable that the heating device is arranged right under the front or rear of the print head. In this case, it is preferable that the heating device is provided to all the processes in which the print head proceeds. Also, the heating device may be arranged above the surface on which the printing is performed. It is preferable that the ultraviolet-curable ink is arranged at the rear of the print head so that the ink is exposed after the printing.

A thermal energy, which causes temperature of the ink composition to be 30 to 90°C when applied to the ink composition, is preferable. A thermal energy, which causes temperature of the ink composition to be 40 to 70°C when applied to the ink composition, is more preferable. Moreover, an ink composition which is cured when heated to 30 to 90°C is preferable. An ink composition which is cured when heated to 40 to 70°C is more preferable.

### EXAMPLES

The present invention will be illustrated in more detail with reference to the following Examples, but the following Examples are only exemplifications for suitably illustrating the invention, and do not limit the invention. In the following illustrations, "parts" and "%" are based on mass (weight) unless otherwise described.

### Example 1

Optical densities shown in the following Examples were measured using a spectrophotometer (product name: U-2000 produced by Hitachi, Ltd).

ELASLON N284SB (product name) supplied from Tokyo Ohka Kogyo Co., Ltd. was used as a photosensitive flexo printing material. Back exposure was performed from the back side of the cover sheet of this photosensitive flexo printing material with the ultra-violet rays having a center wavelength of 370 nm with light exposure of 75 mJ/cm².

A heat-curable ink (resin ink black supplied from Niki Electronics) including pigments having absorption characteristics for the light in a wavelength region of 300 to 400 nm was used as an ink composition to print a print pattern on a surface of the photosensitive resin layer of the flexo printing material.

Moreover, a flat head ink jet printer (FLJ300) supplied from Roland DG Corporation, in which improvement has been made so that a surface of the photosensitive resin side of the flexo printing material is heated immediately after printing, was used as a printing device.

The cover sheet of the photosensitive flexo printing material, to which the back exposure has been performed, was detached. The heat-curable ink was jetted in a predetermined pattern on an exposed surface of the photosensitive resin layer by use of the ink jet printer, thereby printing a predetermined print pattern. The print pattern may generally be an image of a text or a picture, and in the present Example, a text pattern was printed. By use of the ink jet printer, the print pattern was heated to 40°C and cured immediately after printing the print pattern, thereby forming a pattern mask.

Bleeding was not recognized in the contour line when the cured pattern mask was observed by visual inspection. Also, an optical density in the pattern mask was measured, and found to be 3.0.

Subsequently, main exposure of 4000 mJ/cm² was performed to the photosensitive resin layer through the pattern mask. After this exposure, development was performed at a liquid temperature of 25°C for 4 min using an aromatic hydrocarbon based developer (product name: FDO-S2 supplied from Tokyo Ohka Kogyo Co., Ltd.). The plate face after the developing was observed by visual inspection, and no developmental residue was observed on the plate face.

After the development, the plate was dried at 55°C for 50 min, subsequently a first spare post-exposure was performed using an ultraviolet fluorescent lamp having a wavelength centered on 250 nm, and further a main post-exposure at 3000 mJ/cm² was performed using the ultraviolet light having the wavelength centered on 370 nm. A flexo printing plate was obtained by these processes.

Printing was performed using the produced flexographic plate, and consequently a printed matter having a sharp text was obtained.

### Example 2

A predetermined print pattern was printed similarly to the case of Example 1 except that an ultraviolet-curing ink (UV-curable ink black supplied from NUR Macroprinters, Ltd.) was used as an ink composition to print a print pattern on the surface of the photosensitive resin layer, and that a UV ink jet printer (a flat head UV ink jet printer supplied from Sanwa Sangyo Co., Ltd.) with a function to radiate ultra-violet rays on the print pattern immediately after the print was used as a printing device. The print pattern may be an image of a text or a picture, and in the present Example, a text pattern was printed. By use of the ink jet printer, the print pattern was radiated with ultraviolet rays and cured immediately after printing the print pattern, thereby forming a pattern mask.

The characteristic was evaluated by the same way as in Example 1. Bleeding was not recognized in the contour line when the cured pattern mask was observed by visual inspection. An optical density in the pattern mask was measured, and found to be 3.0. The plate face after the developing was observed by visual inspection, and no developmental residue was observed on the plate face. Printing was performed using the produced flexographic plate, and consequently a printed matter having a sharp text was obtained.

### Example 3

A predetermined print pattern was printed, thereby forming a pattern mask, similarly to the case of Example 1, except that the following heat-curable ink including pigments having absorption characteristics to the light in a wavelength region of 300 to 400 nm was used as an ink composition to print a print pattern on a surface of the photosensitive resin layer.

### [Composition of heat-curable ink]

water 51.9%
diethylene glycol 12.0%
acrylic resin 5.0%
pigment black 7 25.0%
triethanolamine 5.0%
Fluoraz (3M Company) (polyglycol hexaether) 0.1%
alphatic alcohol polyglycols ether 1.0%

The characteristic was evaluated by the same way as in Example 1. Bleeding was not recognized in the contour line when the cured pattern mask was observed by visual inspection. An optical density in the pattern mask was measured, and found to be 3.0. The plate face after the developing was observed by visual inspection, and no developmental residue was observed on the plate face. Printing was performed using the produced flexographic plate, and consequently a printed matter having a sharp text was obtained.

### Example 4

A predetermined print pattern was printed, thereby forming a pattern mask, similarly to the case of Example 1, except that the following heat-curable ink including pigments having absorption characteristics to the light in a wavelength region of 300 to 400 nm was used as an ink composition to print a print pattern on a surface of the photosensitive resin layer.

### [Composition of heat-curable ink]

water 62.5%
n-propylalcohol 1.6%
diethylene glycol 28.8%
Eastman Polyester AQ29 (Eastman Chemical Company) 3.5%
pigment black 7 3.5%
Fluoraz (3M Company) (polyglycol hexaether) 0.1%

The characteristic was evaluated by the same way as in Example 1. Bleeding was not recognized in the contour line when the cured pattern mask was observed by visual inspection. An optical density in the pattern mask was measured, and found to be 3.0. The plate face after the developing was observed by visual inspection, and no developmental residue was observed on the plate face. Printing was performed using the produced flexographic plate, and consequently a printed matter having a sharp text was obtained.

### Comparative Example 1

ELASLON N284SB (product name) supplied from Tokyo Ohka Kogyo Co., Ltd. was used as a photosensitive flexo printing material. Back exposure was performed from the back side of the cover sheet of this photosensitive flexo printing material with the ultra-violet rays having a center wavelength of 370 nm with light exposure of 75 mJ/cm².

A water based ink (water based ink black supplied from Seiko Epson Corporation) in common use as an ink for an ink jet printer was used as an ink composition to print a print pattern on a surface of the photosensitive resin layer of the flexo printing material.

Moreover, a flat head ink jet printer (FLJ300) supplied from Roland DG Corporation was used as a printing device.

The cover sheet of the photosensitive flexo printing material, to which the back exposure has been performed, was detached. The water based ink was jetted in a predetermined pattern on an exposed surface of the photosensitive resin layer by use of the ink jet printer, thereby printing a predetermined print pattern. The print pattern may be an image of a text or a picture, and in the present Comparative Example, a text pattern was printed. The print pattern was fixed by drying at room temperature.

Severe bleeding was recognized in the contour line when the dried pattern mask was observed by visual inspection. An optical density in the pattern mask was measured, and found to be 3.0.

Subsequently, main exposure of 4000 mJ/cm² was performed to the photosensitive resin layer through the pattern mask. After this exposure, development was performed at a liquid temperature of 25°C for 4 min using an aromatic hydrocarbon based developer (product name: FDO-S2 supplied from Tokyo Ohka Kogyo Co., Ltd.). A relief pattern necessary for printing was not formed when the developed plate surface was observed by visual inspection.

### Comparative Example 2

ELASLON N284SB (product name) supplied from Tokyo Ohka Kogyo Co., Ltd. was used as a photosensitive flexo printing material. Back exposure was performed from the back side of the cover sheet of this photosensitive flexo printing material with the ultra-violet rays having a center wavelength of 370 nm with light exposure of 75 mJ/cm².

An aqueous solution of 5% polyvinyl butyral (product name: S-Lec KW-3 supplied from Sekisui Chemical Co., Ltd.) was coated using a bar coater on a PET film as a cover sheet having a thickness of 100 µm so that a coated film thickness after drying was 0.8 µm, dried at 100°C for 5 min and an ink holding layer was formed. An optical density for light with a wavelength of 370 nm of this ink holding layer was measured, and consequently it was 0.0.

Faces of the photosensitive resin layer and the ink holding layer were attached and laminated using a compression roller to afford a multiple layer photosensitive product (flexographic plate) where a support layer-the photosensitive resin layer-the ink holding layer-the cover sheet were sequentially laminated and integrated.

The cover sheet of the resulting flexographic original plate was peeled off, and the water-soluble dye ink containing pigments having absorbance property for the light in the wavelength region of 300 to 400 nm was jetted on the ink holding layer in accordance with a predetermined pattern using a flat bed inkjet printer supplied from Roland D.G. to form a predetermined mask pattern in the ink holding layer. The mask pattern formed in the ink holding layer may be an image of a text or a picture, and in the present Comparative Example, a text pattern was formed. Bleeding was recognized in the contour line when the dried pattern mask was observed by visual inspection, though the bleeding was not as severe as that of Comparative Example 1. An optical density for the light with a wavelength of 370 nm in the mask pattern area formed by the light-shielding ink was measured, and found to be 3.0.

Subsequently, a back exposure at 75 mJ/cm² was performed by irradiating ultraviolet light having a wavelength centered on 370 nm from the side of the support, and consecutively a main exposure at 4000 mJ/cm² was performed from the side of an image layer. Thereafter, development was performed at a liquid temperature of 25°C for 4 min using an aromatic hydrocarbon based developer (product name: FDO-S2 supplied from Tokyo Ohka Kogyo Co., Ltd.) as the developer. No developmental residue was observed on the resulting plate face. After the development, the plate was dried at 55°C for 50 min, subsequently a post-treatment was performed using an ultraviolet fluorescent lamp having a wavelength centered on 250 nm, and further a post-exposure at 3000 mJ/cm² was performed using the ultraviolet light having the wavelength centered on 370 nm to afford a flexographic plate. The relief shape of this flexographic plate was insufficient as a shape suitable for printing. Although the printing was possible by trying to print, the sharpness of characters was low.

### INDUSTRIAL APPLICABILITY

As discussed above, according to the method for producing a photosensitive laminate original printing plate of the present invention, the print pattern of the ink composition printed on the surface of the photosensitive resin layer is quickly cured by applying a predetermined energy, thereby fixing the print pattern on the surface of the photosensitive resin layer without bleeding of the ink constituting the print pattern. By these, a pattern mask with high contour precision can be obtained, thereby making it possible to form a pattern of a photosensitive resin layer suitable for letterpress printing by the exposure through this mask and the development thereafter.

## Claims

1. A method for producing a photosensitive laminate original printing plate for letterpress printing, the method comprising the steps of:
printing a predetermined pattern of a printing ink composition containing a light-blocking substance for absorbing light in a predetermined wavelength region and curable by receiving a predetermined energy on a photosensitive resin layer formed on a support and exhibiting a sensitivity to light in the predetermined wavelength region, or on an intermediate layer formed on the photosensitive resin layer; and
forming a pattern mask by application of the predetermined energy to the print pattern to cure the printing ink composition.

2. The method for producing a photosensitive laminate original printing plate for letterpress printing according to claim 1, wherein the application of the predetermined energy is performed at the same time of, or immediately after, printing the print pattern.

3. The method for producing a photosensitive laminate original printing plate for letterpress printing according to any one of claim 1 or 2, wherein the predetermined energy is a thermal energy.

4. The method for producing a photosensitive laminate original printing plate for letterpress printing according to claim 3, wherein the thermal energy is a thermal energy which causes temperature of the print pattern to be 30 to 90°C by the application of the thermal energy to the print pattern.

5. The method for producing a photosensitive laminate original printing plate for letterpress printing according to any one of claim 1 or 2, wherein the predetermined energy is caused by actinic rays.

6. The method for producing a photosensitive laminate original printing plate for letterpress printing according to claim 1, wherein the printing ink composition is printed to the print pattern by using an ink jet printing device in the step of printing a print pattern.

7. A photosensitive laminate original printing plate for letterpress printing, having been obtained by the method for producing a photosensitive laminate original printing plate for letterpress printing according to claim 1.

8. A method for producing a letterpress printing plate, the method comprising:
an exposing step of radiating light in a predetermined wavelength region through a pattern mask to the photosensitive laminate original printing plate for letterpress printing according to claim 7; and
a developing step of removing a removable part of the photosensitive resin layer with a developing solution.
